# EUROPEAN PATENT APPLICATION

(11) **EP 4 625 499 A1**
(43) Date of publication of application: **01.10.2025**
(21) Application number: 24756125.1
(22) Date of filing: 05.02.2024
(51) Int. Cl.: H01L 29/778, H01L 21/335, H01L 29/06

(54) **SEMICONDUCTOR DEVICE, MANUFACTURING METHOD THEREFOR, CHIP AND ELECTRONIC APPARATUS**

(30) Priority: 17.02.2023 CN 202310165304
(71) Applicant: Huawei Technologies Co., Ltd., Shenzhen, Guangdong 518129 (CN)
(72) Inventor: SHEN, Jianfei, Shenzhen, Guangdong 518129 (CN); CHEN, Zhibin, Shenzhen, Guangdong 518129 (CN); LUO, Ruihong, Shenzhen, Guangdong 518129 (CN); DUAN, Huantao, Shenzhen, Guangdong 518129 (CN)
(74) Representative: Thun, Clemens
(86) International application number: PCT/CN2024/076136
(87) International publication number: WO 2024/169751

(57) **Abstract**

Embodiments of this application provide a semiconductor device and a manufacturing method thereof, a chip, and an electronic device, and relate to the field of semiconductor technologies. The semiconductor device includes a substrate, an aluminum nitride buffer layer, and a heteroepitaxial layer. The aluminum nitride buffer layer is located on a side of the substrate, the aluminum nitride buffer layer includes a first surface and a second surface, and the first surface is farther away from the substrate than the second surface. A plurality of dents are randomly distributed on the first surface, and there are spacings between the bottoms of the dents and the second surface. The heteroepitaxial layer is located on a side that is of the aluminum nitride buffer layer and that is away from the substrate. The semiconductor device is configured to reduce costs while improving crystal quality of the epitaxial layer and controlling stress of the epitaxial layer. The semiconductor device is used in the electronic device, to improve performance of the electronic device.

## Description

This application claims priority to Chinese Patent Application No. 202310165304.2, filed with the China National Intellectual Property Administration on February 17, 2023 and entitled "SEMICONDUCTOR DEVICE AND MANUFACTURING METHOD THEREOF, CHIP, AND ELECTRONIC DEVICE", which is incorporated herein by reference in its entirety.

### TECHNICAL FIELD

This application relates to the field of semiconductor technologies, and in particular, to a semiconductor device and a manufacturing method thereof, a chip, and an electronic device.

### BACKGROUND

Semiconductor materials such as nitride and silicon carbide have excellent physical and chemical properties such as a large band gap, a high breakdown voltage, high power density, radiation resistance, and corrosion resistance, and therefore are widely used in the fields of high-temperature, high-frequency, and high-power electronic devices and the like. A silicon substrate has advantages such as a large size, low price, good thermal conductivity, and compatibility with a complementary metal oxide semiconductor (complementary metal oxide semiconductor, CMOS) process.

A semiconductor device that uses silicon, sapphire, or silicon carbide as a substrate and that uses nitride or silicon carbide as an epitaxial layer has significant advantages in terms of a large size, low costs, compatibility with an existing silicon technology, and the like. However, there is large lattice mismatch and large thermal expansion coefficient mismatch between the substrate and the epitaxial layer. Consequently, the epitaxial layer has densely distributed threading dislocations and large residual stress, and performance and reliability of the semiconductor device are greatly affected.

To solve the foregoing problems, technical roadmaps such as a patterned substrate, a superlattice, and an aluminum gallium nitride layer have been proposed in the world. However, the foregoing technical solutions have no significant effect on controlling of the stress of the epitaxial layer, improvement of crystal quality of the epitaxial layer, and the like. In addition, the foregoing technical solutions bring high additional costs.

### SUMMARY

Embodiments of this application provide a semiconductor device and a manufacturing method thereof, a chip, and an electronic device, to reduce costs while improving crystal quality of an epitaxial layer and controlling stress of the epitaxial layer.

To achieve the foregoing objectives, the following technical solutions are used in embodiments of this application.

According to a first aspect, a semiconductor device is provided. The semiconductor device includes a substrate, an aluminum nitride buffer layer, and a heteroepitaxial layer. The aluminum nitride buffer layer is located on a side of the substrate, the aluminum nitride buffer layer includes a first surface and a second surface, and the first surface is farther away from the substrate than the second surface. A plurality of dents are randomly distributed on the first surface, and there are spacings between the bottoms of the dents and the second surface. The heteroepitaxial layer is located on a side that is of the aluminum nitride buffer layer and that is away from the substrate.

According to the semiconductor device provided in this embodiment of this application, the aluminum nitride buffer layer is disposed between the substrate and the heteroepitaxial layer, the aluminum nitride buffer layer includes the first surface away from the substrate, and the plurality of dents are randomly distributed on the first surface. A plane area of the aluminum nitride buffer layer is reduced by disposing the plurality of dents. Based on this, the heteroepitaxial layer is grown, so that stress accumulation of the heteroepitaxial layer in a growth process can be effectively reduced, and stress torque between the heteroepitaxial layer and the substrate is reduced. This solves a problem that the semiconductor device is curled or cracked due to large residual stress of the epitaxial layer, and facilitates growth of the large-sized heteroepitaxial layer.

In addition, the dent on the first surface of the aluminum nitride buffer layer may further provide sidewall radial force, and threading dislocations generated due to lattice mismatch and thermal expansion coefficient mismatch are deflected and extended to a sidewall of the dent, so that the threading dislocations are annihilated on the sidewall of the dent. This improves lattice quality of the aluminum nitride buffer layer and the heteroepitaxial layer.

Compared with a related technology, in the semiconductor device provided in this embodiment of this application, the substrate is not etched, and no superlattice film layer or aluminum gallium nitride layer is disposed. This effectively reduces costs of the semiconductor device.

In some embodiments, a thickness of the aluminum nitride buffer layer ranges from 10 nm to 1000 nm. In this way, the thickness of the aluminum nitride buffer layer is not excessively small, and the depth of the dent distributed on the first surface of the aluminum nitride buffer layer is not excessively small, so that stress accumulation in a growth process of the heteroepitaxial layer can be effectively reduced by the dent, tensile stress of a film layer disposed on the substrate can be reduced, a stress adjustment capability of the semiconductor device can be improved, dislocation density can be reduced, and lattice quality of the aluminum nitride buffer layer and the heteroepitaxial layer can be improved. In addition, the thickness of the aluminum nitride buffer layer is not excessively large, so that problems that a growth time is excessively long and costs are increased due to an excessively thick film layer can be avoided.

In some embodiments, sizes of openings of the plurality of dents in a direction parallel to the substrate range from 10 nm to 500 nm. In this way, the sizes of the plurality of dents are not excessively small, and the plane area of the aluminum nitride buffer layer may be small, so that stress accumulation in a growth process of the heteroepitaxial layer is reduced, residual stress of a material of a plurality of film layers on the substrate is reduced, a stress adjustment capability of the semiconductor device is improved, and the plurality of dents can deflect threading dislocations via sidewall radial force, and annihilate the threading dislocations on sidewalls of the dents. In addition, the sizes of the plurality of dents are not excessively large, so that the first surface of the aluminum nitride buffer layer is not excessively rough due to existence of the dents, and no extremely thick heteroepitaxial layer grows on the aluminum nitride buffer layer to obtain a smooth surface. This avoids an increase in costs.

In some embodiments, the openings of the plurality of dents are in a shape of a circle, an ellipse, a hexagon, or an irregular pattern.

In some embodiments, the openings of the plurality of dents have different sizes in the direction parallel to the substrate.

In some embodiments, minimum spacings between the plurality of dents are less than 1 µm in the direction parallel to the substrate. In this way, the minimum spacings between the plurality of dents are small, the plurality of dents are densely arranged, and more dents can be formed on the aluminum nitride buffer layer with a fixed area, so that stress accumulation during growth of the heteroepitaxial layer can be better reduced, and stress torque between the heteroepitaxial layer and the substrate can be reduced. This further solves a problem that the semiconductor device is curled or cracked due to large residual stress of the epitaxial layer, and facilitates growth of the large-sized heteroepitaxial layer. In addition, more dents may be formed on the aluminum nitride buffer layer, more threading dislocations may be deflected and extended to sidewalls of the dents, and more threading dislocations are annihilated on the sidewalls of the dents. This further improves lattice quality of the aluminum nitride buffer layer and the heteroepitaxial layer.

In some embodiments, the minimum spacings between the plurality of dents are different in the direction parallel to the substrate.

In some embodiments, spacings between the second surface and the bottoms of the plurality of dents are different.

In some embodiments, the spacings between the second surface and the bottoms of the plurality of dents are greater than or equal to one tenth of the thickness of the aluminum nitride buffer layer.

In some embodiments, the semiconductor device further includes a restoration layer, and the restoration layer is located between the aluminum nitride buffer layer and the heteroepitaxial layer. The restoration layer includes a third surface and a fourth surface, and the third surface is farther away from the substrate than the fourth surface. A plurality of gaps are randomly distributed on the fourth surface, and the gaps extend in a direction perpendicular to the substrate. One gap communicates with one dent, and a size, in a specified direction, of an end that is of the gap and that is away from the dent is less than a size, in the specified direction, of an end that is of the gap and that is close to the dent. The specified direction is parallel to the substrate.

In this embodiment of this application, the restoration layer is disposed between the aluminum nitride buffer layer and the heteroepitaxial layer, the plurality of gaps are randomly distributed on the fourth surface of the restoration layer, and the plurality of gaps may also provide sidewall radial force, so that the threading dislocations generated due to the lattice mismatch and the thermal expansion coefficient mismatch are deflected and extended to sidewalls of the gaps, and the threading dislocations are annihilated on the sidewalls of the gaps. This improves lattice quality of the aluminum nitride buffer layer, the restoration layer, and the heteroepitaxial layer.

In addition, the plurality of gaps in the restoration layer one-to-one correspond to the plurality of dents in the aluminum nitride buffer layer, and a size, in the specified direction, of an end that is of a gap and that is away from a dent is less than a size, in the specified direction, of an end that is of the gap and that is close to the dent, so that the third surface that is of the restoration layer and that is away from the substrate is flatter than the first surface that is of the aluminum nitride buffer layer and that is away from the substrate. This can facilitate growth of the heteroepitaxial layer.

In some embodiments, a size of the gap in the specified direction gradually decreases in a direction that is perpendicular to the substrate and that is away from the substrate.

In some embodiments, the gap is in a conical shape.

In some embodiments, the plurality of gaps have different sizes in the direction perpendicular to the substrate.

In some embodiments, a material of the restoration layer includes aluminum nitride, gallium nitride, or aluminum gallium nitride.

In some embodiments, a thickness of the restoration layer ranges from 10 nm to 1000 nm. In this way, the thickness of the restoration layer is not excessively small, and depths of the gaps in the restoration layer are not excessively small, so that the threading dislocations can be effectively annihilated on the sidewalls of the gaps. This improves lattice quality of the aluminum nitride buffer layer, the restoration layer, and the heteroepitaxial layer. In addition, the third surface that is of the restoration layer and that is away from the substrate may be flatter. This further facilitates growth of the heteroepitaxial layer. In addition, the thickness of the restoration layer is not excessively large, so that an increase in costs caused by an excessively large thickness of the restoration layer and an excessively long growth time can be avoided.

In some embodiments, the semiconductor device further includes an aluminum gallium nitride transition layer, and the aluminum gallium nitride transition layer is located between the restoration layer and the heteroepitaxial layer. The aluminum gallium nitride transition layer is disposed, so that the stress of the heteroepitaxial layer can be further alleviated. This solves a problem that the semiconductor device is curled or cracked due to large residual stress of the epitaxial layer, and facilitates growth of the large-sized heteroepitaxial layer.

In some embodiments, residual strain of a plurality of film layers on the substrate is less than or equal to -0.1%.

In some embodiments, the semiconductor device further includes a first electrode and a second electrode. The first electrode is located on a side that is of the substrate and that is away from the aluminum nitride buffer layer, and the second electrode is located on a side that is of the heteroepitaxial layer and that is away from the substrate; or both the first electrode and the second electrode are located on a side that is of the heteroepitaxial layer and that is away from the substrate.

In some embodiments, the semiconductor device further includes an insertion layer, a barrier layer, a source, a drain, and a gate. The insertion layer is located on the side that is of the heteroepitaxial layer and that is away from the substrate. The barrier layer is located on a side that is of the insertion layer and that is away from the substrate. The source, the drain, and the gate are located on a side that is of the barrier layer and that is away from the substrate.

According to a second aspect, a manufacturing method of a semiconductor device is provided. The manufacturing method includes: forming an aluminum nitride buffer layer on a substrate, and forming a heteroepitaxial layer on a side that is of the aluminum nitride buffer layer and that is away from the substrate. The aluminum nitride buffer layer includes a first surface and a second surface, and the first surface is farther away from the substrate than the second surface. A plurality of randomly distributed dents are spontaneously formed on the first surface by controlling a growth condition of the aluminum nitride buffer layer, and there are spacings between bottoms of the dents and the second surface.

In the semiconductor device manufactured by using the manufacturing method provided in this embodiment of this application, the aluminum nitride buffer layer is disposed between the substrate and the heteroepitaxial layer, and the plurality of dents are randomly distributed on the first surface that is of the aluminum nitride buffer layer and that is away from the substrate. A plane area of the aluminum nitride buffer layer is reduced by disposing the plurality of dents. Based on this, the heteroepitaxial layer is grown, so that stress accumulation of the heteroepitaxial layer in a growth process can be effectively reduced, and stress torque between the heteroepitaxial layer and the substrate is reduced. This solves a problem that the semiconductor device is curled or cracked due to large residual stress of the epitaxial layer, and facilitates growth of the large-sized heteroepitaxial layer.

In addition, the dent on the first surface of the aluminum nitride buffer layer may further provide sidewall radial force, and threading dislocations generated due to lattice mismatch and thermal expansion coefficient mismatch are deflected and extended to a sidewall of the dent, so that the threading dislocations are annihilated on the sidewall of the dent. This improves lattice quality of the aluminum nitride buffer layer and the heteroepitaxial layer.

It should be noted that, in the manufacturing method provided in this embodiment of this application, the plurality of dents are spontaneously formed on the first surface of the aluminum nitride buffer layer, no etching process or etching device is required, and the substrate does not need to be removed from an epitaxial device. This can reduce manufacturing costs of the semiconductor device, simplify a manufacturing process of the semiconductor device, and improve efficiency of manufacturing the semiconductor device.

In some embodiments, forming the aluminum nitride buffer layer on the substrate includes: forming the aluminum nitride buffer layer on the substrate based on a first growth condition, where the first growth condition includes at least one of the following three conditions: A molar ratio of a nitrogen element to an aluminum element is greater than or equal to 2500, a temperature is greater than or equal to 700°C and less than or equal to 1000°C, and pressure is greater than 200 millibars.

In some embodiments, before forming the heteroepitaxial layer on the side that is of the aluminum nitride buffer layer and that is away from the substrate, the manufacturing method further includes: forming a restoration layer on the side that is of the aluminum nitride buffer layer and that is away from the substrate. The restoration layer includes a third surface and a fourth surface, and the third surface is farther away from the substrate than the fourth surface. A plurality of randomly distributed gaps are spontaneously formed on the fourth surface by controlling a growth condition of the restoration layer, and the gaps extend in a direction perpendicular to the substrate. One gap communicates with one dent, a size, in a specified direction, of an end that is of the gap and that is away from the dent is less than a size, in the specified direction, of an end that is of the gap and that is close to the dent, and the specified direction is parallel to the substrate.

In some embodiments, a material of the restoration layer includes aluminum nitride. Forming the restoration layer on the side that is of the aluminum nitride buffer layer and that is away from the substrate includes: forming, based on a second growth condition, the restoration layer on the side that is of the aluminum nitride buffer layer and that is away from the substrate. The second growth condition includes at least one of the following three conditions: A molar ratio of a nitrogen element to an aluminum element is less than or equal to 1500, a temperature is greater than 1000°C and less than or equal to 1300°C, and pressure is less than or equal to 200 millibars.

In some embodiments, a material of the restoration layer includes gallium nitride or aluminum gallium nitride. Forming the restoration layer on the side that is of the aluminum nitride buffer layer and that is away from the substrate includes: forming, based on a third growth condition, the restoration layer on the side that is of the aluminum nitride buffer layer and that is away from the substrate. The third growth condition includes at least one of the following three conditions: A molar ratio of a group V element to a group III element is less than or equal to 3000, a temperature is greater than or equal to 900°C and less than or equal to 1300°C, and pressure is less than or equal to 200 millibars. The group V element includes a nitrogen element, and the group III element includes a gallium element, or the group III element includes an aluminum element and a gallium element.

According to a third aspect, a chip is provided. The chip includes a package substrate and the semiconductor device in any one of the foregoing embodiments, and the semiconductor device is electrically connected to the package substrate.

According to a fourth aspect, an electronic device is provided. The electronic device includes a circuit board and the chip in any one of the foregoing embodiments, and the chip is electrically connected to the circuit board.

For technical effect achieved in the third aspect and the fourth aspect, refer to technical effect achieved in different designs of the first aspect. Details are not described herein again.

### BRIEF DESCRIPTION OF DRAWINGS

To describe technical solutions in this application more clearly, the following briefly describes accompanying drawings required for describing some embodiments of this application. It is clear that the accompanying drawings in the following descriptions are merely accompanying drawings in some embodiments of this application. A person of ordinary skill in the art may further derive other drawings from these accompanying drawings. In addition, the accompanying drawings in the following descriptions may be considered as diagrams, and are not intended to limit an actual size of a product, an actual procedure of a method, an actual time sequence of a signal, and the like in embodiments of this application.
FIG. 1 is a diagram of a structure of an electronic device according to an embodiment of this application;
FIG. 2 is a diagram of a structure of an electronic device according to an embodiment of this application;
FIG. 3 is a diagram of a structure of an electronic device according to an embodiment of this application;
FIG. 4 is a diagram of a structure of a semiconductor device according to an embodiment of this application;
FIG. 5 is a top view of a first surface according to an embodiment of this application;
FIG. 6 is a diagram of another structure of a semiconductor device according to an embodiment of this application;
FIG. 7 is a diagram of still another structure of a semiconductor device according to an embodiment of this application;
FIG. 8A is a diagram of yet another structure of a semiconductor device according to an embodiment of this application;
FIG. 8B is a diagram of still yet another structure of a semiconductor device according to an embodiment of this application;
FIG. 9 is a diagram of a further structure of a semiconductor device according to an embodiment of this application;
FIG. 10 is a flowchart of a manufacturing method of a semiconductor device according to an embodiment of this application;
FIG. 11 is a diagram of a manufacturing state of a semiconductor device according to an embodiment of this application;
FIG. 12 is a flowchart of another manufacturing method of a semiconductor device according to an embodiment of this application;
FIG. 13 is a flowchart of still another manufacturing method of a semiconductor device according to an embodiment of this application;
FIG. 14 is a diagram of a manufacturing state of a semiconductor device according to an embodiment of this application;
FIG. 15 is a flowchart of yet another manufacturing method of a semiconductor device according to an embodiment of this application;
FIG. 16 is a flowchart of still yet another manufacturing method of a semiconductor device according to an embodiment of this application;
FIG. 17 is a flowchart of a further manufacturing method of a semiconductor device according to an embodiment of this application;
FIG. 18 is a flowchart of a still further manufacturing method of a semiconductor device according to an embodiment of this application;
FIG. 19 is a flowchart of a yet further manufacturing method of a semiconductor device according to an embodiment of this application; and
FIG. 20 is a flowchart of a still yet further manufacturing method of a semiconductor device according to an embodiment of this application.

### DESCRIPTION OF EMBODIMENTS

The following describes the technical solutions in embodiments of this application with reference to accompanying drawings in embodiments of this application. In descriptions of this application, unless otherwise specified, "/" indicates an "or" relationship between associated objects. For example, A/B may indicate A or B.

"And/or" in this application describes only an association relationship between associated objects and indicates that three relationships may exist. For example, A and/or B may indicate the following three cases: Only A exists, both A and B exist, and only B exists. A and B may be singular or plural.

In addition, in the descriptions of this application, "a plurality of" means two or more than two unless otherwise specified. "At least one of the following items (pieces)" or a similar expression thereof means any combination of these items, including a singular item (piece) or any combination of plural items (pieces). For example, at least one item (piece) of a, b, or c may indicate: a, b, c, a and b, a and c, b and c, or a, b, and c, where a, b, and c may be singular or plural.

To clearly describe the technical solutions in embodiments of this application, terms such as "first" and "second" are used in embodiments of this application to distinguish between same items or similar items that have basically the same functions and purposes. A person skilled in the art may understand that the terms such as "first" and "second" do not limit a quantity or an execution sequence, and the terms such as "first" and "second" do not indicate a definite difference.

In embodiments of this application, the word "example", "for example", or the like is used to represent giving an example, an illustration, or a description. Any embodiment or design scheme described as an "example" or "for example" in embodiments of this application should not be explained as being more preferred or having more advantages than another embodiment or design scheme. Exactly, use of the terms such as "example" or "for example" is intended to present a related concept in a specific manner for ease of understanding.

An embodiment of this application provides an electronic device. The electronic device may include a communication device (for example, a base station or a mobile phone), a charging device, a small-sized chargeable household appliance (for example, a soy milk machine or a robotic vacuum cleaner), an unmanned aerial vehicle, an aerospace device, a lidar driver, a laser, a detector, a medical device, a radar, a navigation device, a radio frequency (radio frequency, RF) plasma lighting device, an RF sensing or microwave heating device, a display device, or the like. A specific form of the electronic device is not specially limited in embodiments of this application. The electronic device includes a semiconductor device.

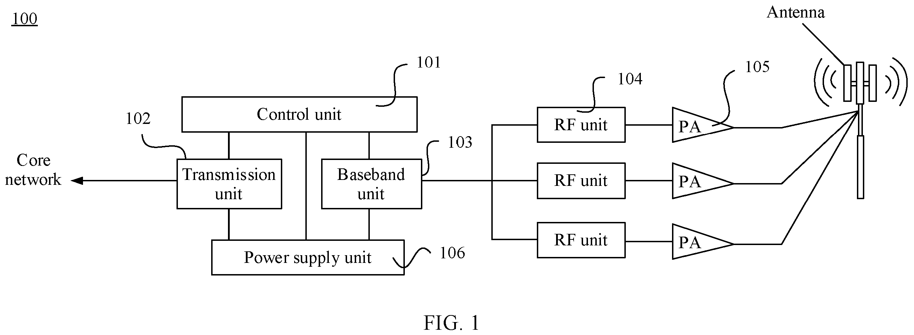

A base station is used as an example. FIG. 1 is a simple diagram of a structure of a base station 100. The base station 100 includes a control unit 101. The control unit 101 in the base station 100 includes a radio transceiver, an antenna, a related signal processing circuit, and the like. The control unit 101 mainly includes four components: a cell controller, a voice channel controller, a signaling channel controller, and a multi-path interface for extension. The control unit 101 of the base station 100 generally controls several base transceiver stations. Through remote commands of the transceiver stations and mobile stations, the control unit 101 of the base station 100 is responsible for management of all mobile communication interfaces, mainly including radio channel allocation, release, and management.

Still refer to FIG. 1. The base station 100 further includes a transmission unit 102. The transmission unit 102 is connected to a core network, control signaling and voice call or data service information on a core network side are sent to the control unit 101 of the base station 100 via the transmission unit 102, and the control unit 101 processes these services.

Further refer to FIG. 1. The base station 100 further includes a baseband unit 103, RF units 104, and power amplifiers (power amplifiers, PAs) 105. The baseband unit 103 mainly completes functions such as baseband modulation and demodulation, radio resource allocation, call processing, power control, and soft handover. The RF unit 104 mainly completes conversion between an air radio frequency channel and a baseband digital channel, the PA 105 amplifies a signal, and then the signal is sent to an antenna via a radio frequency feeder for transmission. A terminal device like a mobile phone (mobile phone) or a tablet computer (pad) receives, through a wireless channel, a radio wave transmitted by the antenna, and then demodulates a signal belonging to the terminal device. The PA mainly amplifies a radio frequency signal.

Still refer to FIG. 1. The base station further includes a power supply unit 106. The power supply unit 106 may be configured to supply power to structures such as the control unit 101, the transmission unit 102, and the baseband unit 103.

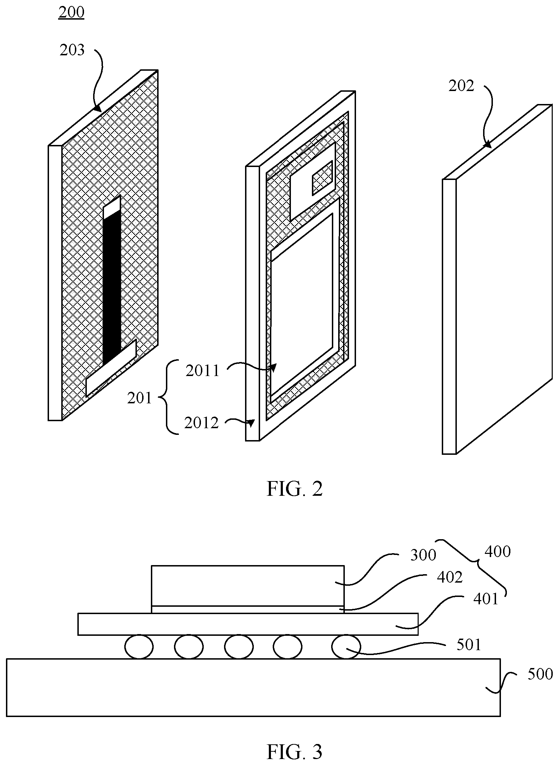

FIG. 2 is a diagram of a structure of another electronic device. A mobile phone is used as an example of the electronic device. The mobile phone 200 may include a middle frame 201, a rear housing 202, and a display 203. The middle frame 201 includes a bearing plate 2011 configured to bear the display 203, and a side frame 2012 surrounding the bearing plate 2011. The bearing plate 2011 bears an RF unit and a PA device. After amplifying a signal output by the RF unit, the PA device feeds the amplified signal to an antenna in the mobile phone (for example, the antenna may be disposed along an edge of the side frame 2012), to receive and send a signal.

A semiconductor device 300 may be integrated into a base station or a mobile phone as a power amplifier. For example, the semiconductor device may be a high electron mobility transistor (high electron mobility transistor, HEMT) device. The HEMT device has advantages such as a high breakdown electric field, high channel electron concentration, high electron mobility, and high temperature stability.

Alternatively, the semiconductor device 300 may be used in an RF unit, and further integrated into a base station or a mobile phone. For example, the semiconductor device may be a bulk acoustic wave (bulk acoustic wave, BAW) filter. Alternatively, for example, the semiconductor device may be a surface acoustic wave (surface acoustic wave, SAW) filter.

In addition to the HEMT device, the BAW filter, and the SAW filter described in the foregoing embodiment, the semiconductor device 300 provided in embodiments of this application may be integrated into another electronic device as a light emitting diode, a laser diode, a storage device, or a detection device.

As shown in FIG. 3, some embodiments of this application further provide a chip 400. The chip 400 includes a package substrate 401 and a semiconductor device 300. The semiconductor device 300 is electrically connected to the package substrate 401.

For example, the semiconductor device 300 may be carried on the package substrate 401, and is electrically connected to the package substrate 401 via an electrical connection structure (for example, a metal layer) 402. The semiconductor device 300 may also be in signal interconnection with another electronic device on the package substrate 401.

The foregoing electronic device may include the chip 400 and a circuit board 500, and the chip 400 is electrically connected to the circuit board 500.

The circuit board 500 may be, for example, a printed circuit board (printed circuit board, PCB). The chip 400 may be carried on the circuit board 500, and is electrically connected to the circuit board 500 via another electrical connection structure 501. The another electrical connection structure 501 herein may be a ball grid array (ball grid array, BGA) or another electrical connection structure.

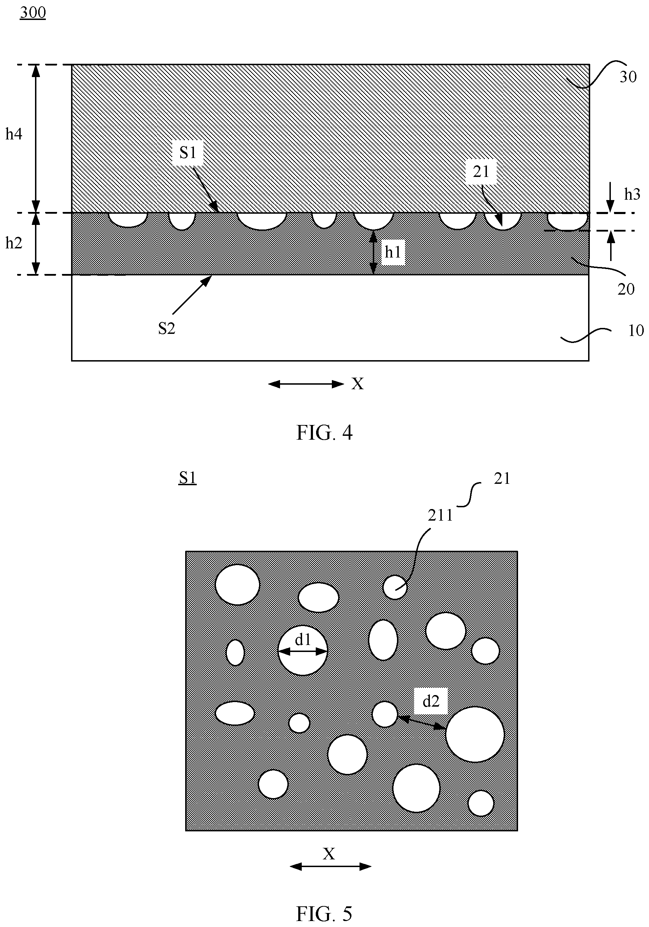

As shown in FIG. 4, an embodiment of this application provides a semiconductor device 300. The semiconductor device 300 includes a substrate 10, an aluminum nitride buffer layer 20, and a heteroepitaxial layer 30. The aluminum nitride buffer layer 20 is located on a side of the substrate 10, the aluminum nitride buffer layer 20 includes a first surface S1 and a second surface S2, and the first surface S1 is farther away from the substrate 10 than the second surface S2. A plurality of dents 21 are randomly distributed on the first surface S1, and there are spacings h1 (h1>0) between the bottoms of the dents 21 and the second surface S2. The heteroepitaxial layer 30 is located on a side that is of the aluminum nitride buffer layer 20 and that is away from the substrate 10.

A material of the substrate 10 may include silicon (Si), silicon carbide (SiC), sapphire, gallium nitride (GaN), or the like. When the material of the substrate includes the silicon, the substrate 10 may be a silicon on insulator (silicon on insulator, SOI) substrate, and the SOI substrate includes a top silicon layer, an intermediate insulation layer, and a bottom silicon layer. Alternatively, the substrate 10 may be a silicon wafer.

When the material of the substrate 10 includes the silicon, a crystal orientation of the silicon may be <100> or <111>.

The substrate 10 may be of an N type, a P type, or an intrinsic type. When the substrate 10 is of the N type or the P type, the substrate 10 may be electrically conductive, and higher concentration of particles doped in the substrate 10 indicates lower resistivity of the substrate 10.

In some examples, the substrate 10 may be a high-resistance substrate containing silicon. For example, the high-resistance substrate containing silicon may be of a substrate structure with resistivity greater than or equal to 1000 Ω·cm, or may be of a substrate structure with resistivity greater than or equal to 2000 Ω·cm, or may be of a substrate structure with resistivity greater than or equal to 5000 Ω·cm. The high-resistance substrate containing silicon is used in a device (for example, an RF device) that operates at a high frequency. This can reduce a substrate loss, and optimize performance of the semiconductor device 300.

In some other examples, the substrate 10 may alternatively be a low-resistance substrate containing silicon. For example, the low-resistance substrate containing silicon may be of a substrate structure with resistivity less than 1000 Ω·cm, or may be of a substrate structure with resistivity less than 2000 Ω·cm, or may be of a substrate structure with resistivity less than 5000 Ω·cm. The low-resistance substrate including silicon is used in a device (for example, a charging switch) operating at a high voltage. Because the low-resistance substrate including silicon has high concentration of doped particles and high flexibility, a large quantity of epitaxial film layers (for example, superlattice structures) can be grown on the low-resistance substrate containing silicon. This can improve breakdown resistance of the semiconductor device 300.

A size, a shape, and a thickness of the substrate 10 are not limited in embodiments of this application, and may be designed based on an actual requirement. For example, the size of the substrate 10 may be 4 inches to 18 inches. For example, the size of the substrate 10 may be 4 inches, 6 inches, 8 inches, 10 inches, 12 inches, 14 inches, 16 inches, 18 inches, or the like.

In this embodiment of this application, a material of the aluminum nitride buffer layer 20 is aluminum nitride. In a process of growing the aluminum nitride buffer layer 20, migration of aluminum atoms is suppressed by controlling a growth condition, to control a growth trend of the aluminum nitride, so that the aluminum nitride grows fast in a direction perpendicular to the substrate 10, and grows slow in a direction parallel to the substrate 10, and the plurality of randomly distributed dents 21 are spontaneously formed on the first surface S1. In this way, no etching process is required. This reduces costs, and simplifies a flow of manufacturing the semiconductor device 300.

As shown in FIG. 4, the aluminum nitride buffer layer 20 includes the first surface S1 and the second surface S2, and the first surface S1 and the second surface S2 are disposed opposite to each other.

The plurality of dents 21 are randomly distributed on the first surface S1 of the aluminum nitride buffer layer 20. To be specific, the plurality of dents 21 on the first surface S1 of the aluminum nitride buffer layer 20 are aperiodically distributed, and each dent 21 may be located at any possible position on the first surface S1.

"There are spacings h1 between the bottoms of the dents 21 and the second surface S2". To be specific, there is the spacing h1 between the second surface S2 and an end that is of the dent 21 and that is close to the substrate 10, or there is the spacing between the second surface S2 and a point that is on a surface of the dent 21 and that is closest to the substrate 10.

"There are spacings h1 between the bottoms of the dents 21 and the second surface S2". In other words, a depth h3 of the dent 21 is less than a thickness h2 of the aluminum nitride buffer layer 20.

In some embodiments, spacings h1 between the second surface S2 and the bottoms of the plurality of dents 21 are different. In other words, depths h3 of the plurality of dents 21 are different.

"Spacings h1 between the second surface S2 and the bottoms of the plurality of dents 21 are different" may be that spacings h1 between the second surface S2 and the bottoms of any two of the plurality of dents 21 are different (in other words, the depths h3 of all the dents 21 are different from each other), or may be that spacings h1 between the second surface S2 and the bottoms of some dents 21 are the same and spacings h1 between the second surface S2 and the bottoms of the other dents 21 are different (in other words, depths h3 of the some dents 21 are the same, and depths h3 of the other dents 21 are different).

In some embodiments, the spacings h1 between the second surface S2 and the bottoms of the plurality of dents 21 are greater than or equal to one tenth of the thickness h2 of the aluminum nitride buffer layer 20. In other words, the depth h3 of the dent 21 is less than or equal to nine tenths of the aluminum nitride buffer layer 20. This facilitates reduction of growth difficulty of the aluminum nitride buffer layer 20, makes manufacturing of the aluminum nitride buffer layer 20 simpler, and improves efficiency of manufacturing the aluminum nitride buffer layer 20.

In some examples, a material of the heteroepitaxial layer 30 may include a group III element nitride, for example, one or a combination of at least two of boron nitride (BN), aluminum nitride (AlN), gallium nitride (GaN), indium nitride (InN), and thallium nitride (TIN). Alternatively, a material of the heteroepitaxial layer 30 may include a ternary compound or quaternary compound formed by a group III element and a group V element, for example, aluminum gallium nitride (AlGaN), indium gallium nitride (InGaN), aluminum indium gallium nitride (AlInGaN), or gallium arsenic phosphorus nitride (GaAsPbN).

In some other examples, a material of the heteroepitaxial layer 30 may include silicon carbide.

A thickness h4 of the heteroepitaxial layer 30 is not limited in embodiments of this application, and may be designed based on an actual requirement.

In some possible examples, the thickness h4 of the heteroepitaxial layer 30 may be 200 nm to 2 µm. For example, the thickness of the heteroepitaxial layer 30 may be 200 nm, 500 nm, 800 nm, 1000 nm, 1500 nm, or 2000 nm.

Through X-ray diffraction (X-ray diffraction, XRD) reciprocal space mapping (mapping) measurement, in the semiconductor device 300 provided in this embodiment of this application, residual strain of a plurality of film layers (for example, the aluminum nitride buffer layer 20 and the heteroepitaxial layer 30) on the substrate 10 is less than or equal to -0.1% (that is, residual tensile strain is less than or equal to 0.1%), and a stress control capability is improved by 29%.

Through XRD rocking curve measurement for (002) and (102) planes, in the semiconductor device 300 provided in this embodiment of this application, a sum of screw dislocation density and edge dislocation density in the plurality of film layers (for example, the aluminum nitride buffer layer 20 and the heteroepitaxial layer 30) on the substrate 10 is decreased by 66%, and lattice quality is improved by 66%.

In the semiconductor device 300 provided in this embodiment of this application, the aluminum nitride buffer layer 20 is disposed between the substrate 10 and the heteroepitaxial layer 30, the aluminum nitride buffer layer 20 includes the first surface S1 away from the substrate 10, and the plurality of dents 21 are randomly distributed on the first surface S1. A plane area of the aluminum nitride buffer layer 20 is reduced by disposing the plurality of dents 21. Based on this, the heteroepitaxial layer 30 is grown, so that stress accumulation of the heteroepitaxial layer 30 in a growth process can be effectively reduced, and stress torque between the heteroepitaxial layer 30 and the substrate 10 is reduced. This solves a problem that the semiconductor device is curled or cracked due to large residual stress of the epitaxial layer, and facilitates growth of the large-sized (for example, greater than 6 inches) heteroepitaxial layer 30.

In addition, the dent 21 on the first surface S1 of the aluminum nitride buffer layer 20 may further provide sidewall radial force, and threading dislocations generated due to lattice mismatch and thermal expansion coefficient mismatch are deflected and extended to a sidewall of the dent 21, so that the threading dislocations are annihilated on the sidewall of the dent 21. This improves lattice quality of the aluminum nitride buffer layer 20 and the heteroepitaxial layer 30.

Compared with a related technology, in the semiconductor device 300 provided in this embodiment of this application, the substrate is not etched, and no superlattice film layer or aluminum gallium nitride layer is disposed. This effectively reduces costs of the semiconductor device 300.

As shown in FIG. 4, the thickness h2 of the aluminum nitride buffer layer 20 may be 10 nm to 1000 nm. For example, the thickness of the aluminum nitride buffer layer h2 may be 10 nm, 50 nm, 80 nm, 100 nm, 200 nm, 500 nm, 800 nm, or 1000 nm.

In this way, the thickness of the aluminum nitride buffer layer 20 is not excessively small, and the depth of the dent 21 distributed on the first surface S1 of the aluminum nitride buffer layer 20 is not excessively small, so that stress accumulation in the growth process of the heteroepitaxial layer 30 can be effectively reduced by the dent 21, tensile stress of the film layer disposed on the substrate 10 can be reduced, a stress adjustment capability of the semiconductor device 300 can be improved, dislocation density can be reduced, and lattice quality of the aluminum nitride buffer layer 20 and the heteroepitaxial layer 30 can be improved. In addition, the thickness of the aluminum nitride buffer layer 20 is not excessively large, so that problems that a growth time is excessively long and costs are increased due to an excessively thick film layer can be avoided.

In some embodiments, as shown in FIG. 5, sizes d1 of openings 211 of the plurality of dents 21 in a direction X parallel to the substrate 10 range from 10 nm to 500 nm. For example, the sizes d1 of the openings 211 of the plurality of dents 21 in the direction X parallel to the substrate 10 may be 10 nm, 50 nm, 100 nm, 200 nm, 300 nm, 400 nm, or 500 nm.

It may be understood that there are a plurality of directions X parallel to the substrate 10. In this embodiment of this application, "sizes d1 of openings 211 of the plurality of dents 21 in a direction X parallel to the substrate 10 range from 10 nm to 500 nm", that is, in any direction X parallel to the substrate 10, the sizes d1 of the openings 211 of the plurality of dents 21 range from 10 nm to 500 nm.

In this way, the sizes of the plurality of dents 21 are not excessively small, and the plane area of the aluminum nitride buffer layer 20 may be small, so that stress accumulation in the growth process of the heteroepitaxial layer 30 is reduced, residual stress of a material of the plurality of film layers on the substrate 10 is reduced, a stress adjustment capability of the semiconductor device 300 is improved, and the plurality of dents 21 can deflect threading dislocations via sidewall radial force, and annihilate the threading dislocations on sidewalls of the dents 21. In addition, the sizes of the plurality of dents 21 are not excessively large, so that the first surface S1 of the aluminum nitride buffer layer 20 is not excessively rough due to existence of the dents, and no extremely thick heteroepitaxial layer grows on the aluminum nitride buffer layer 20 to obtain a smooth surface. This avoids an increase in costs.

In some embodiments, the openings of the plurality of dents 21 may be in a shape of a circle, an ellipse, a hexagon, or an irregular pattern.

In some examples, the openings of the plurality of dents 21 may be the same in shape. In this case, the openings of the plurality of dents 21 may be uniformly in a shape of any one of a circle, an ellipse, a hexagon, or an irregular pattern.

In some other examples, the openings of the plurality of dents 21 may be different in shape. For example, as shown in FIG. 5, in the plurality of dents 21, openings of some dents 21 are in a shape of a circle, and openings of the other dents 21 are in a shape of an ellipse. Alternatively, in the plurality of dents 21, openings of some dents 21 are in a shape of a circle, openings of some dents 21 are in a shape of an ellipse, and openings of the remaining dents 21 are in a shape of a hexagon. Alternatively, in the plurality of dents 21, openings of some dents 21 are in a shape of a circle, openings of some dents 21 are in a shape of an ellipse, openings of some dents 21 are in a shape of a hexagon, and the remaining dents 21 are in a shape of an irregular pattern.

As shown in FIG. 5, in some embodiments, the sizes d1 of the openings 211 of the plurality of dents 21 are different in the direction X parallel to the substrate 10.

"The sizes of the openings 211 of the plurality of dents 21 are different in the direction X parallel to the substrate 10" may be that the sizes d1 of the openings 211 of all the dents 21 are different in the direction X parallel to the substrate 10, or may be that sizes d1 of openings 211 of some dents 21 are the same and sizes d1 of openings 211 of some dents 21 are different in the direction X parallel to the substrate 10.

As shown in FIG. 5, in some embodiments, minimum spacings d2 between the plurality of dents 21 are less than 1 micrometer (µm) in the direction parallel to the substrate 10. For example, the minimum spacings d2 between the plurality of dents 21 may be 10 nm, 20 nm, 50 nm, 100 nm, 200 nm, 500 nm, or 900 nm.

In this way, the minimum spacings d2 between the plurality of dents 21 are small, the plurality of dents 21 are densely arranged, and more dents 21 can be formed on the aluminum nitride buffer layer 20 with a fixed area, so that stress accumulation during growth of the heteroepitaxial layer 30 can be better reduced, and stress torque between the heteroepitaxial layer 30 and the substrate 10 can be reduced. This further solves a problem that the semiconductor device is curled or cracked due to large residual stress of the epitaxial layer, and facilitates growth of the large-sized heteroepitaxial layer 30. In addition, more dents 21 may be formed on the aluminum nitride buffer layer 20, more threading dislocations may be deflected and extended to sidewalls of the dents 21, and more threading dislocations are annihilated on the sidewalls of the dents 21. This further improves lattice quality of the aluminum nitride buffer layer 20 and the heteroepitaxial layer 30.

In some embodiments, as shown in FIG. 5, the minimum spacings d2 between the plurality of dents 21 are different in the direction X parallel to the substrate 10.

"The minimum spacings d2 between the plurality of dents 21 are different in the direction X parallel to the substrate 10" may be that a minimum spacing d2 between at least one pair of dents 21 is different from a minimum spacing d2 between the other two adjacent dents 21.

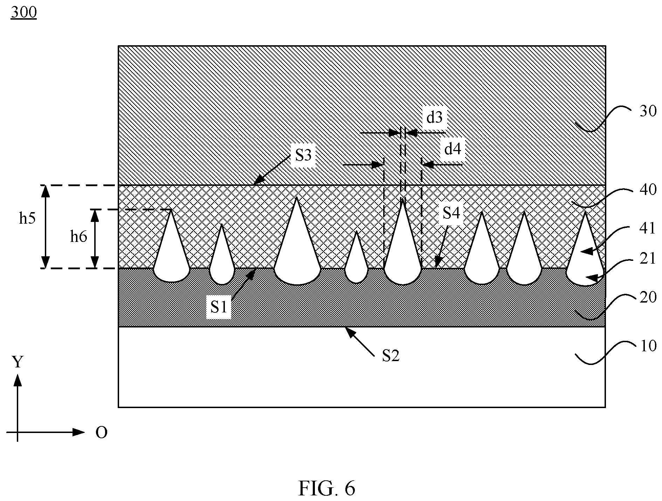

In some embodiments, as shown in FIG. 6, the semiconductor device 300 further includes a restoration layer 40, and the restoration layer 40 is located between the aluminum nitride buffer layer 20 and the heteroepitaxial layer 30. The restoration layer 40 includes a third surface S3 and a fourth surface S4, and the third surface S3 is farther away from the substrate 10 than the fourth surface S4. A plurality of gaps 41 are randomly distributed on the fourth surface S4, and the gaps 41 extend in a direction Y perpendicular to the substrate 10. One gap 41 communicates with one dent 21, and a size d3, in a specified direction O, of an end that is of the gap 41 and that is away from the dent 21 is less than a size d4, in the specified direction O, of an end that is of the gap 41 and that is close to the dent 21. The specified direction O is parallel to the substrate 10.

As shown in FIG. 6, the third surface S3 and the fourth surface S4 are disposed opposite to each other.

For example, a material of the restoration layer 40 may include aluminum nitride, gallium nitride, or aluminum gallium nitride.

When the material of the restoration layer 40 includes the aluminum nitride, the gallium nitride, or the aluminum gallium nitride, a growth trend of the aluminum nitride, the gallium nitride, or the aluminum gallium nitride may be controlled by controlling a growth condition, so that the aluminum nitride, the gallium nitride, or the aluminum gallium nitride grows fast in the direction parallel to the substrate 10, and grows slow in the direction perpendicular to the substrate 10; and the dents on the first surface S1 of the aluminum nitride buffer layer 20 are gradually blocked by the aluminum nitride, the gallium nitride, or the aluminum gallium nitride. This improves flatness of a surface on which the heteroepitaxial layer 30 grows.

In this embodiment of this application, the restoration layer 40 is disposed between the aluminum nitride buffer layer 20 and the heteroepitaxial layer 30, the plurality of gaps 41 are randomly distributed on the fourth surface S4 of the restoration layer 40, and the plurality of gaps 41 may also provide sidewall radial force, so that the threading dislocations generated due to the lattice mismatch and the thermal expansion coefficient mismatch are deflected and extended to sidewalls of the gaps 41, and the threading dislocations are annihilated on the sidewalls of the gaps 41. This improves lattice quality of the aluminum nitride buffer layer 20, the restoration layer 40, and the heteroepitaxial layer 30.

In addition, the plurality of gaps 41 in the restoration layer 40 one-to-one correspond to the plurality of dents 21 in the aluminum nitride buffer layer 20, and a size, in the specified direction O, of an end that is of a gap 41 and that is away from a dent 21 is less than a size, in the specified direction O, of an end that is of the gap 41 and that is close to the dent 21, so that the third surface S3 that is of the restoration layer 40 and that is away from the substrate 10 is flatter than the first surface S1 that is of the aluminum nitride buffer layer 20 and that is away from the substrate 10. This can facilitate growth of the heteroepitaxial layer 30.

When the semiconductor device further includes the restoration layer 40, through X-ray diffraction reciprocal space mapping measurement, residual strain of a plurality of film layers (namely, the aluminum nitride buffer layer 20, the restoration layer 40, and the heteroepitaxial layer 30) on the substrate 10 is also less than or equal to -0.1%.

In some examples, a thickness h5 of the restoration layer 40 may be 10 nm to 1000 nm. For example, the thickness h5 of the restoration layer 40 may be 10 nm, 20 nm, 50 nm, 100 nm, 200 nm, 500 nm, 800 nm, or 1000 nm.

In this way, the thickness h5 of the restoration layer 40 is not excessively small, and depths of the gaps 41 in the restoration layer 40 are not excessively small, so that the threading dislocations can be effectively annihilated on the sidewalls of the gaps 41. This improves lattice quality of the aluminum nitride buffer layer 20, the restoration layer 40, and the heteroepitaxial layer 30. In addition, the third surface S3 that is of the restoration layer 40 and that is away from the substrate 10 may be flatter. This further facilitates growth of the heteroepitaxial layer 30. In addition, the thickness h5 of the restoration layer 40 is not excessively large, so that an increase in costs caused by an excessively large thickness of the restoration layer and an excessively long growth time can be avoided.

It may be understood that a size (depth) h6 of the gap 41 in the direction perpendicular to the substrate 10 is less than or equal to the thickness h5 of the restoration layer 40.

In some examples, the plurality of gaps 41 have different sizes h6 in the direction perpendicular to the substrate 10. In this case, sizes h6 of all the gaps 41 in the direction perpendicular to the substrate 10 may be different; or sizes h6 of some gaps in the plurality of gaps 41 in the direction perpendicular to the substrate 10 may be the same, and sizes h6 of the other gaps 41 in the direction perpendicular to the substrate 10 may be the same.

In some examples, as shown in FIG. 6, a size of the gap 41 in the specified direction O gradually decreases in a direction that is perpendicular to the substrate and that is away from the substrate 10.

In some examples, as shown in FIG. 6, the plurality of gaps 41 may be in a conical shape.

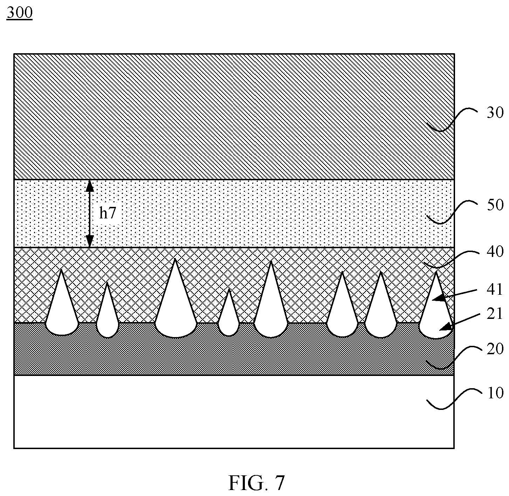

As shown in FIG. 7, in some embodiments, the semiconductor device 300 further includes an aluminum gallium nitride transition layer 50, and the aluminum gallium nitride transition layer 50 is located between the restoration layer 40 and the heteroepitaxial layer 30.

The aluminum gallium nitride transition layer 50 is disposed, so that the stress of the heteroepitaxial layer 30 can be further alleviated. This solves a problem that the semiconductor device is curled or cracked due to large residual stress of the epitaxial layer, and facilitates growth of the large-sized heteroepitaxial layer 30.

In some examples, a composition of aluminum in the aluminum gallium nitride transition layer 50 may be between a composition of aluminum in the restoration layer 40 and a composition of aluminum in the heteroepitaxial layer 30.

In some examples, a thickness h7 of the aluminum gallium nitride transition layer 50 may be 100 nm to 1000 nm. For example, the thickness of the aluminum gallium nitride transition layer 50 may be 100 nm, 200 nm, 300 nm, 500 nm, 800 nm, or 1000 nm.

This can not only adjust stress, and but also avoid an increase in costs caused by an excessively large thickness of the aluminum gallium nitride transition layer 50 and an excessively long growth time.

In some embodiments, the semiconductor device 300 is a BAW filter. A basic principle of the BAW filter is that electrodes at the top and bottom of a piezoelectric material excite a bulk acoustic wave under piezoelectric effect.

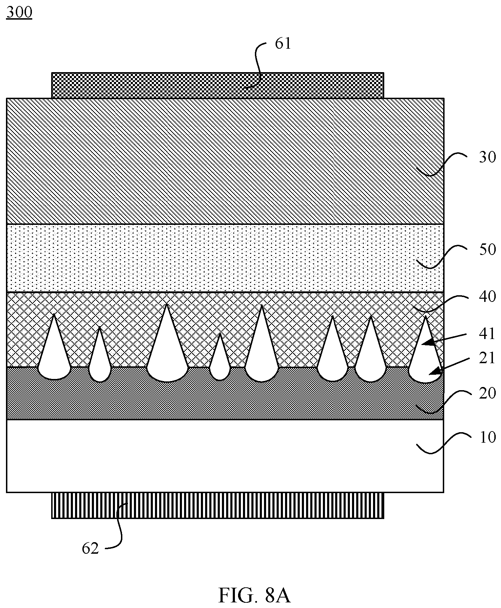

In this case, as shown in FIG. 8A, the semiconductor device 300 may further include a first electrode 61 and a second electrode 62. The first electrode 61 is located on a side that is of the substrate 10 and that is away from the aluminum nitride buffer layer 20, and the second electrode 62 is located on a side that is of the heteroepitaxial layer 30 and that is away from the substrate 10.

The heteroepitaxial layer 30 is used as a piezoelectric material, and excites a bulk acoustic wave under action of the first electrode 61 and the second electrode 62.

For example, both the first electrode 61 and the second electrode 62 may be plate electrodes.

In some other embodiments, the semiconductor device 300 is a SAW filter. A basic principle of the SAW filter is that a radio signal is converted into an acoustic signal at an input end under piezoelectric effect, and the acoustic signal is converted into the radio signal at an output end under inverse piezoelectric effect.

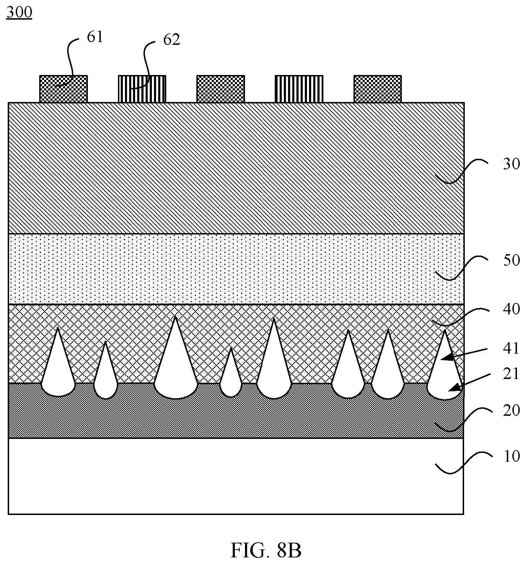

In this case, as shown in FIG. 8B, the semiconductor device 300 may include a first electrode 61 and a second electrode 62. Both the first electrode 61 and the second electrode 62 are located on a side that is of the heteroepitaxial layer 30 and that is away from the substrate 10. One of the first electrode 61 and the second electrode 62 is used as an input of the SAW filter, and the other is used as an output of the SAW filter. The heteroepitaxial layer 30 is used as a piezoelectric material, and excites a surface acoustic wave under action of the first electrode 61 or the second electrode 62.

For example, both the first electrode 61 and the second electrode 62 may be interdigital electrodes.

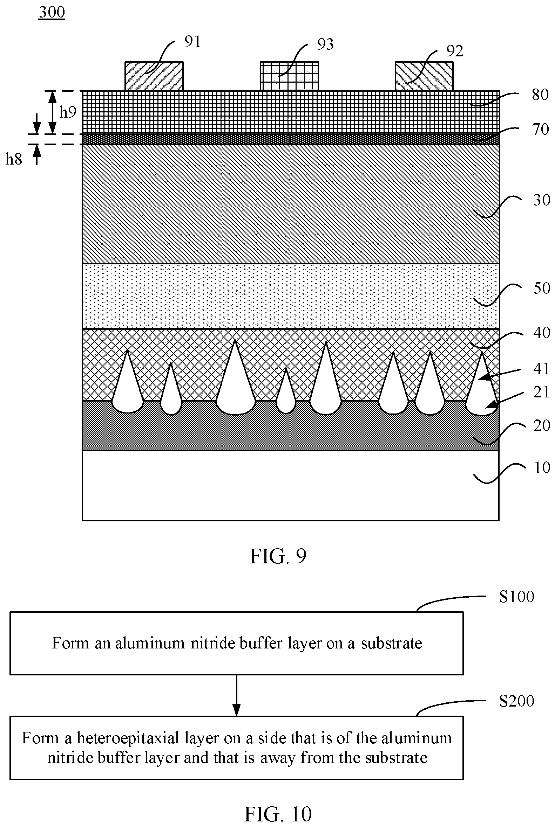

In some other embodiments, the semiconductor device 300 is an HEMT device. In this case, as shown in FIG. 9, the semiconductor device 300 may further include an insertion layer 70, a barrier layer 80, a source 91, a drain 92, and a gate 93. The insertion layer 70 is located on a side that is of the heteroepitaxial layer 30 and that is away from the substrate 10. The barrier layer 80 is located on a side that is of the insertion layer 70 and that is away from the substrate 10. The source 91, the drain 92, and the gate 93 are located on a side that is of the barrier layer 80 and that is away from the substrate 10.

When the heteroepitaxial layer 30 is located in the HEMT device, the heteroepitaxial layer 30 may be used as a channel layer in the HEMT device. Two-dimensional electron gas (two-dimensional electron gas, 2DEG) may be generated between the heteroepitaxial layer 30 and the barrier layer 80 under polarization effect, to conduct a current.

The insertion layer 70 is located between the heteroepitaxial layer 30 and the barrier layer 80, to increase concentration of the two-dimensional electron gas, reduce an amount of the two-dimensional electron gas penetrating into the barrier layer, and reduce disordered scattering of an alloy, thereby increasing electron mobility and improving output characteristics of the semiconductor device.

The source 91 and the drain 92 separately form ohmic contact with the barrier layer 80, and the gate 93 forms Schottky contact with the barrier layer 80. The source 91 and the drain 92 are configured to enable the 2DEG to flow in the insertion layer 70 between the source 91 and the drain 92 under action of an electric field, and conduction between the source 91 and the drain 92 occurs at the two-dimensional electron gas in the insertion layer 70. The gate 93 is disposed between the source 91 and the drain 92 to allow or hinder passing of the two-dimensional electron gas.

For example, a material of the insertion layer 70 may include aluminum nitride.

For example, a material of the barrier layer 80 may be aluminum gallium nitride, aluminum indium nitride (AlInN), or aluminum indium gallium nitride.

When the material of the barrier layer 80 includes the aluminum gallium nitride, a composition of aluminum in the aluminum gallium nitride may be 10% to 30%. For example, the composition of the aluminum may be 10%, 20%, or 30%. In this way, the concentration of the two-dimensional electron gas formed between the barrier layer 80 and the heteroepitaxial layer 30 may be high.

In the HEMT device, a thickness h4 of the heteroepitaxial layer 30 may be 50 nm to 1000 nm. For example, the thickness h4 of the heteroepitaxial layer 30 may be 50 nm, 100 nm, 200 nm, 500 nm, 800 nm, or 1000 nm.

As the thickness of the heteroepitaxial layer 30 increases, polarization effect between the heteroepitaxial layer 30 and the barrier layer is first enhanced and then weakened. In this embodiment of this application, the thickness of the heteroepitaxial layer is 50 nm to 1000 nm. This can avoid problems that because the heteroepitaxial layer is excessively thick, the polarization effect is weakened, the concentration of the two-dimensional electron gas is reduced, and manufacturing costs of the semiconductor device are increased. In addition, in this embodiment of this application, the thickness of the heteroepitaxial layer is 50 nm to 1000 nm. This can further avoid a problem that mobility of the two-dimensional electron gas is reduced because the heteroepitaxial layer is excessively thin and lattice quality of the heteroepitaxial layer is poor.

In some examples, a thickness h8 of the insertion layer 70 may be less than or equal to 5 nm. For example, the thickness h8 of the insertion layer 70 may be 1 nm, 2 nm, 3 nm, 4 nm, or 5 nm. This improves the concentration of the 2DEG.

In some examples, a thickness h9 of the barrier layer 80 may be 5 nm to 30 nm. For example, the thickness h9 of the barrier layer 80 may be 5 nm, 10 nm, 15 nm, 20 nm, or 30 nm.

Similar to that of the heteroepitaxial layer 30, as the thickness h9 of the barrier layer 80 increases, the polarization effect between the heteroepitaxial layer 30 and the barrier layer 80 is first enhanced and then weakened. In this embodiment of this application, the thickness h9 of the barrier layer 80 is 5 nm to 30 nm. This can avoid problems that because the thickness h9 of the barrier layer 80 is excessively large, the polarization effect is weakened, the concentration of the two-dimensional electron gas is reduced, and the manufacturing costs of the semiconductor device are increased.

Because the two-dimensional electron gas is generated between the heteroepitaxial layer 30 and the barrier layer 80 under the polarization effect, and the polarization effect is mainly piezoelectric polarization, when stress of the heteroepitaxial layer 30 and the barrier layer 80 is different, concentration of two-dimensional electron gas generated between the heteroepitaxial layer 30 and the barrier layer 80 is also different. In this embodiment of this application, the aluminum nitride buffer layer 20 is disposed, to reduce residual stress of a plurality of film layers on the substrate 10, and further increase the concentration of the two-dimensional electron gas. For example, in a device Hall (Hall) test, two-dimensional electron concentration in the semiconductor device 300 provided in this embodiment of this application is 1×10¹² cm⁻².

The mobility of the two-dimensional electron gas is related to lattice quality. Higher lattice quality indicates higher mobility of the two-dimensional electron gas. In this embodiment of this application, the dent 21 on the first surface S1 of the aluminum nitride buffer layer 20 may further provide the sidewall radial force, and the threading dislocations generated due to the lattice mismatch and the thermal expansion coefficient mismatch are deflected and extended to the sidewall of the dent 21, so that the threading dislocations are annihilated on the sidewall of the dent 21. This improves the lattice quality of the aluminum nitride buffer layer 20 and the heteroepitaxial layer 30 is improved, and can further increase the mobility of the two-dimensional electron gas. For example, in a device Hall (Hall) test, the mobility of the two-dimensional electron gas in the semiconductor device 300 provided in this embodiment of this application may be 2390 cm²/(V·S).

It can be learned from concentration data of the two-dimensional electron gas and mobility data of the two-dimensional electron gas in the semiconductor device 300 that, when the semiconductor device 300 is the HEMT device, the HEMT device may have good electrical performance.

In some other embodiments, the semiconductor device 300 is a light emitting diode (light emitting diode, LED) device. In this case, the semiconductor device 300 may further include an N-type conducting layer, a multi-quantum-well active layer, and a P-type conducting layer. The N-type conducting layer is located on a side that is of the heteroepitaxial layer and that is away from the substrate, the multi-quantum-well active layer is located on a side that is of the N-type conducting layer and that is away from the substrate, and the P-type conducting layer is located on a side that is of the multi-quantum-well active layer and that is away from the substrate.

An embodiment of this application further provides a manufacturing method of a semiconductor device 300. As shown in FIG. 10, the manufacturing method of the semiconductor device 300 includes the following steps.

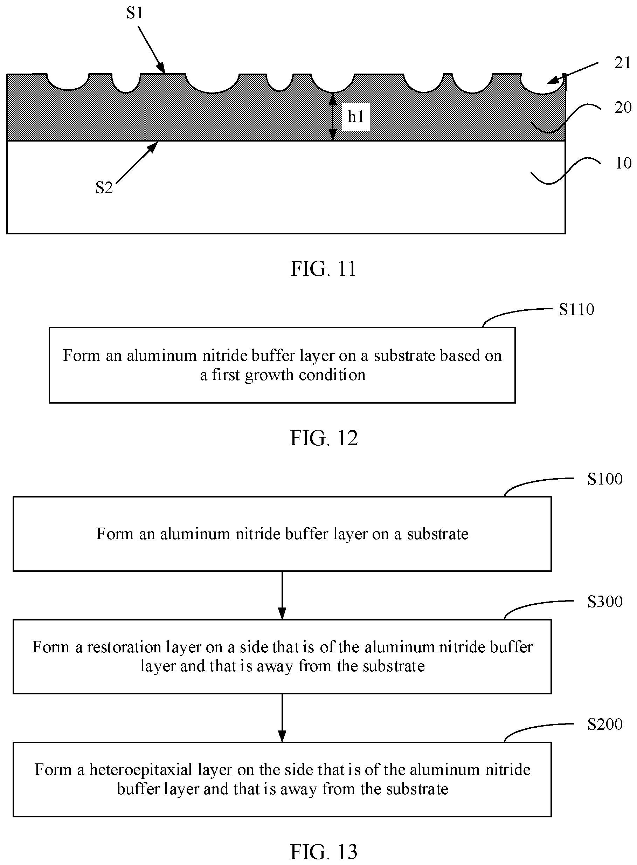

S100: As shown in FIG. 11, form an aluminum nitride buffer layer 20 on a substrate 10, where the aluminum nitride buffer layer 20 includes a first surface S1 and a second surface S2, and the first surface S1 is farther away from the substrate 10 than the second surface S2. A plurality of randomly distributed dents 21 are spontaneously formed on the first surface S1 by controlling a growth condition of the aluminum nitride buffer layer 20. There are spacings h1 between bottoms of the dents 21 and the second surface S2.

In some examples, trimethylaluminium and ammonia gas may be used as an Al source and an N source respectively, and hydrogen gas is used as carrier gas, to grow the aluminum nitride buffer layer 20 in an epitaxial device.

S200: As shown in FIG. 4, form a heteroepitaxial layer 30 on a side that is of the aluminum nitride buffer layer 20 and that is away from the substrate 10.

In some examples, a material of the heteroepitaxial layer 30 may include a group III element nitride, for example, one or a combination of at least two of boron nitride, aluminum nitride, gallium nitride, indium nitride, and thallium nitride. Alternatively, a material of the heteroepitaxial layer 30 may include a ternary compound or quaternary compound formed by a group III element and a group V element, for example, indium gallium nitride, aluminum indium gallium nitride, or gallium arsenic phosphorus nitride.

In some other examples, a material of the heteroepitaxial layer 30 may include silicon carbide.

When the material of the heteroepitaxial layer 30 is the gallium nitride, trimethylgallium may be used as a Ga source, ammonia gas may be used as an N source, and hydrogen gas may be used as carrier gas, to grow the heteroepitaxial layer 30 in the epitaxial device.

In the semiconductor device 300 manufactured by using the manufacturing method provided in this embodiment of this application, the aluminum nitride buffer layer 20 is disposed between the substrate 10 and the heteroepitaxial layer 30, and the plurality of dents 21 are randomly distributed on the first surface S1 that is of the aluminum nitride buffer layer 20 and that is away from the substrate 10. An area of a consecutive plane of the aluminum nitride buffer layer 20 is reduced by disposing the plurality of dents 21. Based on this, the heteroepitaxial layer 30 is grown, so that stress accumulation of the heteroepitaxial layer 30 in a growth process can be effectively reduced, and stress torque between the heteroepitaxial layer 30 and the substrate 10 is reduced. This solves a problem that the semiconductor device is curled or cracked due to large residual stress of the epitaxial layer, and facilitates growth of the large-sized heteroepitaxial layer 30.

In addition, the dent 21 on the first surface S1 of the aluminum nitride buffer layer 20 may further provide sidewall radial force, and threading dislocations generated due to lattice mismatch and thermal expansion coefficient mismatch are deflected and extended to a sidewall of the dent 21, so that the threading dislocations are annihilated on the sidewall of the dent 21. This improves lattice quality of the aluminum nitride buffer layer 20 and the heteroepitaxial layer 30.

It should be noted that, in the manufacturing method provided in this embodiment of this application, the plurality of dents 21 are spontaneously formed on the first surface S1 by controlling the growth condition of the aluminum nitride buffer layer 20, no etching process or etching device is required, and the substrate does not need to be removed from the epitaxial device. This can reduce manufacturing costs of the semiconductor device, simplify a manufacturing process of the semiconductor device, and improve efficiency of manufacturing the semiconductor device.

In addition, the plurality of dents 21 in the aluminum nitride buffer layer 20 provided in this embodiment of this application are formed through random migration of aluminum atoms in the process of forming the aluminum nitride buffer layer 20. Both a size of the dent 21 and a size of a crystal pillar formed by the aluminum atoms are at a nanometer level. Therefore, a size of an opening of the dent 21 may be small. In this way, compared with a method of patterning the substrate, in this embodiment of this application, after the aluminum nitride buffer layer 20 is formed, no extremely thick heteroepitaxial layer is grown to obtain a smooth surface. This avoids an increase in costs.

In some embodiments, metal-organic chemical vapor deposition (metal-organic chemical vapor deposition, MOCVD), molecular beam epitaxy (molecular beam epitaxy, MBE), or physical vapor deposition (physical vapor deposition, PVD) is used as a growth technology, the aluminum nitride buffer layer 20 is grown on the substrate 10, and the heteroepitaxial layer 30 is formed on the side that is of the aluminum nitride buffer layer 20 and that is away from the substrate 10.

As shown in FIG. 12, in some embodiments, step S100 of forming the aluminum nitride buffer layer 20 on the substrate 10 includes the following step.

S110: Form the aluminum nitride buffer layer 20 on the substrate 10 based on a first growth condition. The first growth condition includes at least one of the following three conditions: A molar ratio of a nitrogen element to an aluminum element is greater than or equal to 2500, a temperature is greater than or equal to 700°C and less than or equal to 1000°C, and pressure is greater than 200 millibars (mb).

In some examples, the first growth condition may include one of the three conditions.

For example, the first growth condition may include that the molar ratio of the nitrogen element to the aluminum element is greater than or equal to 2500.

When the molar ratio of the nitrogen element to the aluminum element is greater than or equal to 2500, there is a large amount of ammonia gas in a growth chamber, and the aluminum atoms are easily bonded with a nitrogen element in the ammonia gas, and do not easily migrate in a direction parallel to the substrate 10, so that aluminum nitride molecules grow fast in a direction perpendicular to the substrate 10, and grow slow in the direction parallel to the substrate 10, to form the dents 21 on the first surface S1 that is of the aluminum nitride buffer layer 20 and that is away from the substrate 10.

For another example, the first growth condition may include that the temperature is greater than or equal to 700°C and less than or equal to 1000°C.

When the temperature is greater than or equal to 700°C and less than or equal to 1000°C, it can be ensured that a raw material can be normally decomposed, and a migration rate of aluminum atoms in a direction parallel to the substrate 10 can be reduced, so that aluminum nitride molecules grow fast in a direction perpendicular to the substrate 10, and grow slow in the direction parallel to the substrate 10, to form the dents 21 on the first surface S1 that is of the aluminum nitride buffer layer 20 and that is away from the substrate 10.

For another example, the first growth condition may include that the pressure is greater than 200 millibars.

Similarly, when the pressure is greater than 200 millibars, a migration rate of aluminum atoms in a direction parallel to the substrate 10 is low, so that aluminum nitride molecules grow fast in a direction perpendicular to the substrate 10, and grow slow in the direction parallel to the substrate 10, to form the dents 21 on the first surface S1 that is of the aluminum nitride buffer layer 20 and that is away from the substrate 10.

In some other examples, the first growth condition may include two of the three conditions.

For example, the first growth condition may include that the molar ratio of the nitrogen element to the aluminum element is greater than or equal to 2500 and the temperature is greater than or equal to 700°C and less than or equal to 1000°C. For another example, the first growth condition may include that the molar ratio of the nitrogen element to the aluminum element is greater than or equal to 2500 and that the pressure is greater than 200 millibars. For another example, the first growth condition may include that the temperature is greater than or equal to 700°C and less than or equal to 1000°C and that the pressure is greater than 200 millibars.

In this way, a migration rate of aluminum atoms in a direction parallel to the substrate 10 can be further reduced by controlling two conditions, so that aluminum nitride grows fast in a direction perpendicular to the substrate 10, and grows slow in the direction parallel to the substrate 10, to form more dents 21 or arrange more dense dents 21 on the first surface S1 that is of the aluminum nitride buffer layer 20 and that is away from the substrate 10.

In some other examples, the first growth condition may include all the three conditions. To be specific, the first growth condition includes that the molar ratio of the nitrogen element to the aluminum element is greater than or equal to 2500, the temperature is greater than or equal to 700°C and less than or equal to 1000°C, and that the pressure is greater than 200 millibars.

In this way, a migration rate of aluminum atoms in a direction parallel to the substrate 10 can be further reduced, so that aluminum nitride molecules grow faster in a direction perpendicular to the substrate 10, and grow slower in the direction parallel to the substrate 10, a quantity of dents 21 formed on the first surface S1 that is of the aluminum nitride buffer layer 20 and that is away from the substrate 10 is increased, and a distance between the dents 21 is smaller.

As shown in FIG. 13, in some embodiments, before step 200 of forming the heteroepitaxial layer 30 on the side that is of the aluminum nitride buffer layer 20 and that is away from the substrate 10, the manufacturing method further includes the following step.

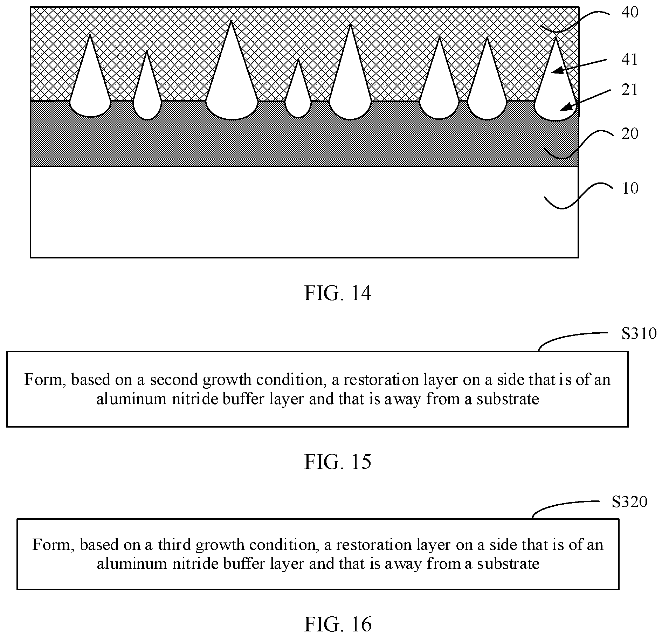

S300: As shown in FIG. 6 and FIG. 14, form a restoration layer 40 on the side that is of the aluminum nitride buffer layer 20 and that is away from the substrate 10. The restoration layer 40 includes a third surface S3 and a fourth surface S4, and the third surface S3 is farther away from the substrate 10 than the fourth surface S4. A plurality of randomly distributed gaps 41 are spontaneously formed on the fourth surface S4 by controlling a growth condition of the restoration layer 40, and the gaps 41 extend in a direction perpendicular to the substrate 10. One gap 41 communicates with one dent 21, and a size, in a specified direction O, of an end that is of the gap 41 and that is away from the dent 21 is less than a size, in the specified direction O, of an end that is of the gap 41 and that is close to the dent 21. The specified direction O is parallel to the substrate 10.

It may be understood that, when the restoration layer 40 is formed on the aluminum nitride buffer layer 20, a material of the restoration layer is mainly grown on a plane (a part other than the dent on the first surface) of the aluminum nitride buffer layer 20, so that the gaps 41 are distributed on the fourth surface S4 that is of the restoration layer 40 and that is close to the substrate 10, and one gap 41 communicates with one dent 21.

According to the manufacturing method provided in this embodiment of this application, the plurality of gaps 41 are spontaneously formed on the fourth surface S4, and the plurality of gaps 41 may also provide sidewall radial force, so that threading dislocations generated due to lattice mismatch and thermal expansion coefficient mismatch are deflected and extended to sidewalls of the gaps 41, and the threading dislocations are annihilated on the sidewalls of the gaps 41. This improves lattice quality of the aluminum nitride buffer layer 20 and the heteroepitaxial layer 30. The plurality of gaps 41 are spontaneously formed, no etching process or etching device is required, and the substrate does not need to be removed from an epitaxial device. This can reduce manufacturing costs of the semiconductor device, simplify a manufacturing process of the semiconductor device, and improve efficiency of manufacturing the semiconductor device.

In addition, the size, in the specified direction O, of the end that is of the gap 41 and that is away from the dent 21 is less than the size, in the specified direction O, of the end that is of the gap 41 and that is close to the dent 21, so that the third surface S3 of the restoration layer 40 is flatter than the first surface S1 of the aluminum nitride buffer layer 20. This facilitates growth of the heteroepitaxial layer 30.

In some examples, metal-organic chemical vapor deposition, molecular beam epitaxy, or physical vapor deposition may be used as a growth technology, to form the restoration layer 40.

In some examples, a material of the restoration layer 40 includes aluminum nitride, gallium nitride, or aluminum gallium nitride.

When the material of the restoration layer 40 includes the aluminum nitride, the gallium nitride, or the aluminum gallium nitride, a growth trend of the aluminum nitride, the gallium nitride, or the aluminum gallium nitride may be controlled by controlling a growth condition, so that the aluminum nitride, the gallium nitride, or the aluminum gallium nitride grows fast in the direction parallel to the substrate 10, and grows slow in the direction perpendicular to the substrate 10; and the dents on the first surface S1 of the aluminum nitride buffer layer 20 are gradually blocked by the aluminum nitride, the gallium nitride, or the aluminum gallium nitride. This improves flatness of a surface on which the heteroepitaxial layer 30 grows.

A growth condition of the restoration layer 40 in a case in which the material of the restoration layer 40 is the aluminum nitride is slightly different from a growth condition of the restoration layer 40 in a case in which the material of the restoration layer 40 is the gallium nitride or aluminum gallium nitride, the following describes growth conditions of the restoration layer 40 of different materials.

As shown in FIG. 15, when a material of the restoration layer 40 includes aluminum nitride, step 300 of forming the restoration layer 40 on the side that is of the aluminum nitride buffer layer 20 and that is away from the substrate 10 includes the following step.

S310: Form, based on a second growth condition, the restoration layer 40 on the side that is of the aluminum nitride buffer layer 20 and that is away from the substrate 10. The second growth condition includes at least one of the following three conditions: A molar ratio of a nitrogen element to an aluminum element is less than or equal to 1500, a temperature is greater than 1000°C and less than or equal to 1300°C, and pressure is less than or equal to 200 millibars.

When the molar ratio of the nitrogen element to the aluminum element is less than or equal to 1500, there is a small amount of ammonia gas in a growth chamber, aluminum atoms are not easily bonded with the nitrogen element, and the aluminum atoms are easily migrated in a direction parallel to the substrate 10, so that aluminum nitride molecules grow fast in the direction parallel to the substrate 10, and grow slow in a direction perpendicular to the substrate 10, to spontaneously form gaps 41 corresponding to dents 21, on the restoration layer 40, and a size, in a specified direction O, of an end that is of the gap 41 and that is away from the dent 21 is less than a size, in the specified direction O, of an end that is of the gap 41 and that is close to the dent 21.

Similarly, when the temperature is greater than 1000°C and less than or equal to 1300°C, a growth temperature is high, so that a migration rate of aluminum atoms in a direction parallel to the substrate 10 is also high. When the pressure is less than or equal to 200 millibars, ambient pressure is small, so that a migration rate of aluminum atoms in a direction parallel to the substrate 10 is high. In this way, when the temperature is greater than 1000°C and less than or equal to 1300°C, or when the pressure is less than or equal to 200 millibars, aluminum nitride grows fast in the direction parallel to the substrate 10, and grows slow in a direction perpendicular to the substrate 10, to spontaneously form gaps 41 corresponding to dents 21, on the restoration layer 40, and a size, in a specified direction O, of an end that is of the gap 41 and that is away from the dent 21 is less than a size, in the specified direction O, of an end that is of the gap 41 and that is close to the dent 21.

In some examples, the second growth condition may include one of the three conditions. For example, the second growth condition may include that the molar ratio of the nitrogen element to the aluminum element is less than or equal to 1500. For another example, the second growth condition may include that the temperature is greater than 1000°C and less than or equal to 1300°C. For another example, the second growth condition may include that the pressure is less than or equal to 200 millibars.

In some other examples, the second growth condition may include two of the three conditions.

For example, the second growth condition may include that the molar ratio of the nitrogen element to the aluminum element is less than or equal to 1500, and the temperature is greater than 1000°C and less than or equal to 1300°C. For another example, the second growth condition may include that the molar ratio of the nitrogen element to the aluminum element is less than or equal to 1500 and that the pressure is less than or equal to 200 millibars. For another example, the second growth condition may include that the temperature is greater than 1000°C and less than or equal to 1300°C and that the pressure is less than or equal to 200 millibars.

In this way, the migration rate of the aluminum atoms in the direction parallel to the substrate 10 can be further increased by controlling two conditions, so that the aluminum nitride grows fast in the direction parallel to the substrate 10, and grows slow in the direction perpendicular to the substrate 10; and a size of an end that is of the gap 41 and that is away from the dent 21 is small in the direction parallel to the substrate, or a depth of the gap 41 is small.

In some other examples, the second growth condition may include all the three conditions. To be specific, the second growth condition includes that the molar ratio of the nitrogen element to the aluminum element is less than or equal to 1500, the temperature is greater than 1000°C and less than or equal to 1300°C, and that the pressure is less than or equal to 200 millibars.

In this way, the migration rate of the aluminum atoms in the direction parallel to the substrate 10 can be further increased, so that the aluminum nitride molecules grow faster in the direction parallel to the substrate 10, and grow slower in the direction perpendicular to the substrate 10; and a size of an end that is of the gap 41 and that is away from the dent 21 may be smaller in the direction parallel to the substrate, or a depth of the gap 41 may be smaller.

As shown in FIG. 16, when a material of the restoration layer 40 includes gallium nitride or aluminum gallium nitride, step 300 of forming the restoration layer 40 on the side that is of the aluminum nitride buffer layer 20 and that is away from the substrate 10 includes the following step.

S320: Form, based on a third growth condition, the restoration layer 40 on the side that is of the aluminum nitride buffer layer 20 and that is away from the substrate 10. The third growth condition includes at least one of the following three conditions: A molar ratio of a group V element to a group III element is less than or equal to 3000, a temperature is greater than or equal to 900°C and less than or equal to 1300°C, and pressure is less than or equal to 200 millibars. The group V element includes a nitrogen element, and the group III element includes a gallium element, or the group III element includes an aluminum element and a gallium element.

It may be understood that, when the material of the restoration layer 40 includes the gallium nitride, the group V element includes the nitrogen element, and the group III element may include the gallium element. When the material of the restoration layer 40 includes the aluminum gallium nitride, the group V element includes the nitrogen element, and the group III element may include the aluminum element and the gallium element.

In some examples, the third growth condition may include one of the three conditions.

When the molar ratio of the group V element to the group III element is less than or equal to 3000, or the temperature is greater than or equal to 900°C and less than or equal to 1300°C, or the pressure is less than or equal to 200 millibars, the gallium nitride or the aluminum gallium nitride can grow fast in a direction parallel to the substrate 10, and grow slow in a direction perpendicular to the substrate 10, to spontaneously form gaps 41 corresponding to dents 21, on the restoration layer 40, and a size, in a specified direction O, of an end that is of the gap 41 and that is away from the dent 21 is less than a size, in the specified direction O, of an end that is of the gap 41 and that is close to the dent 21.

In some other examples, the third growth condition may include two of the three conditions. For example, the third growth condition may include that the molar ratio of the group V element to the group III element is less than or equal to 3000 and the temperature is greater than or equal to 900°C and less than or equal to 1300°C. For another example, the third growth condition may include that the molar ratio of the group V element to the group III element is less than or equal to 3000 and that the pressure is less than or equal to 200 millibars. For another example, the third growth condition may include that the temperature is greater than or equal to 900°C and less than or equal to 1300°C and that the pressure is less than or equal to 200 millibars.

In this way, a growth speed of the gallium nitride or the aluminum gallium nitride in a direction parallel to the substrate 10 can be further increased, and a growth speed of the gallium nitride or the aluminum gallium nitride in a direction perpendicular to the substrate 10 can be further reduced, by controlling two conditions, so that a size of an end that is of a gap 41 and that is away from a dent 21 is smaller in the direction parallel to the substrate, or a depth of the gap 41 is smaller.

In some other examples, the third growth condition may include all the three conditions. To be specific, the third growth condition may include that the molar ratio of the group V element to the group III element is less than or equal to 3000, the temperature is greater than or equal to 900°C and less than or equal to 1300°C, and that the pressure is less than or equal to 200 millibars.

In this way, a growth speed of the gallium nitride or the aluminum gallium nitride in a direction parallel to the substrate 10 can be further increased, and a growth speed of the gallium nitride or the aluminum gallium nitride in a direction perpendicular to the substrate 10 can be further reduced, so that a size of an end that is of a gap 41 and that is away from a dent 21 is smaller in the direction parallel to the substrate, or a depth of the gap 41 is smaller.

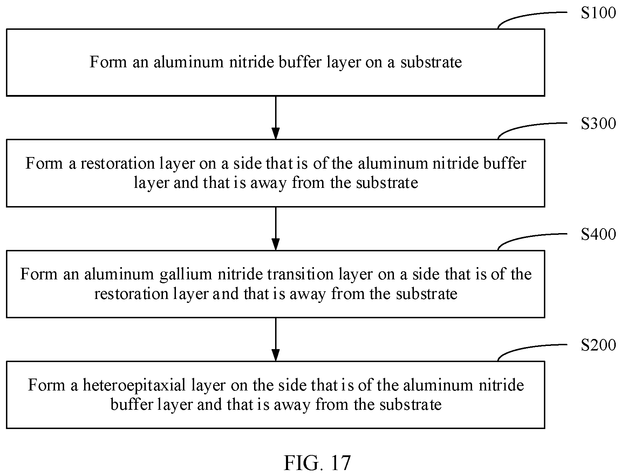

In some embodiments, after step S300 of forming the restoration layer 40 on the side that is of the aluminum nitride buffer layer 20 and that is away from the substrate 10, and before step 200 of forming the heteroepitaxial layer 30 on the side that is of the aluminum nitride buffer layer 20 and that is away from the substrate 10, as shown in FIG. 17, the manufacturing method may further include the following steps.

S400: Form an aluminum gallium nitride transition layer 50 on a side that is of the restoration layer 40 and that is away from the substrate 10.

For example, metal-organic chemical vapor deposition, molecular beam epitaxy, or physical vapor deposition may be used as a growth technology, trimethylgallium, trimethylaluminium, and ammonia gas may be used as a gallium source, an aluminum source, and a nitrogen source respectively, and hydrogen gas may be used as carrier gas, to form the aluminum gallium nitride transition layer 50.

A reaction temperature at which the aluminum gallium nitride transition layer 50 is formed is not limited in embodiments of this application. For example, when the aluminum gallium nitride transition layer 50 is formed on the side that is of the restoration layer 40 and that is away from the substrate 10, the reaction temperature may be 1060°C.

The semiconductor device provided in this embodiment of this application may be a bulk acoustic wave filter, a surface acoustic wave filter, an HEMT device, or the like.

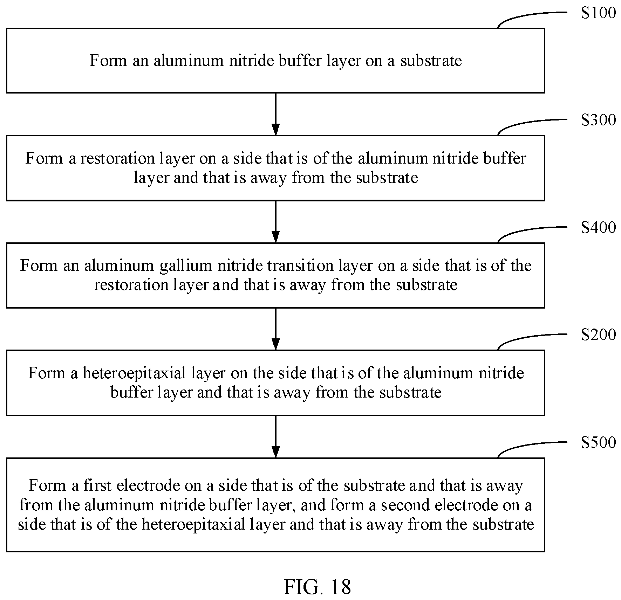

When the semiconductor device 300 is the bulk acoustic wave filter, after step S200 of forming the heteroepitaxial layer 30 on the side that is of the aluminum nitride buffer layer 20 and that is away from the substrate 10, as shown in FIG. 8A and FIG. 18, the manufacturing method may further include the following step.

S500: Form a first electrode 61 on a side that is of the substrate 10 and that is away from the aluminum nitride buffer layer 20, and form a second electrode 62 on a side that is of the heteroepitaxial layer 30 and that is away from the substrate 10.

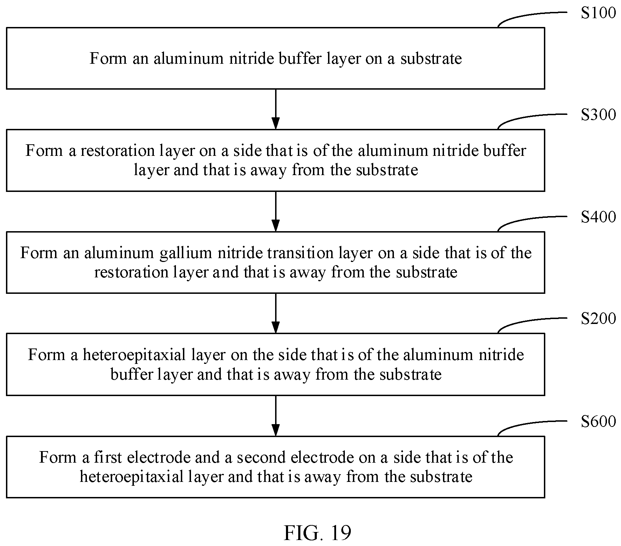

When the semiconductor device 300 is the surface acoustic wave filter, after step S200 of forming the heteroepitaxial layer 30 on the side that is of the aluminum nitride buffer layer 20 and that is away from the substrate 10, as shown in FIG. 8B and FIG. 19, the manufacturing method may further include the following step.

S600: Form a first electrode 61 and a second electrode 62 on a side that is of the heteroepitaxial layer 30 and that is away from the substrate 10.

A manner of forming the first electrode 61 and the second electrode 62 is not limited in embodiments of this application. For example, the first electrode 61 and the second electrode 62 may be formed by using a deposition process (for example, sputtering) and an etching process.

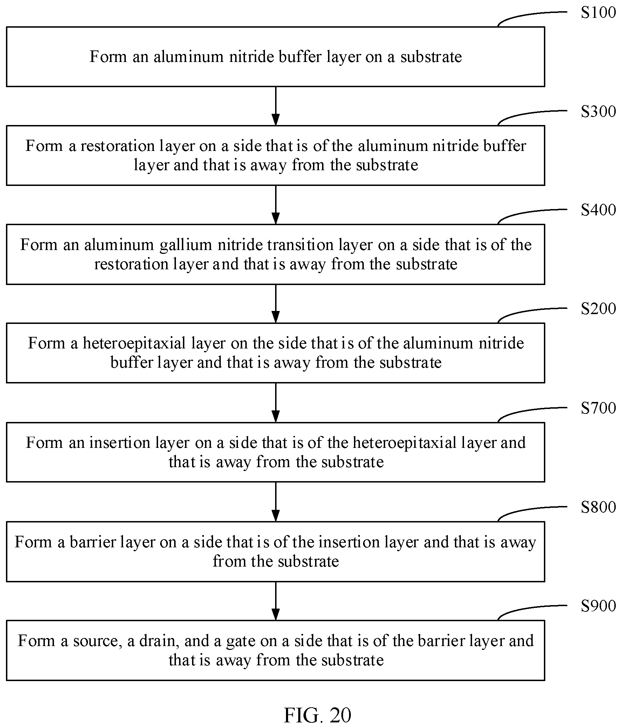

When the semiconductor device 300 is the HEMT, after step S200 of forming the heteroepitaxial layer 30 on the side that is of the aluminum nitride buffer layer 20 and that is away from the substrate 10, as shown in FIG. 9 and FIG. 20, the manufacturing method may further include the following steps.

S700: Form an insertion layer 70 on a side that is of the heteroepitaxial layer 30 and that is away from the substrate 10.

S800: Form a barrier layer 80 on a side that is of the insertion layer 70 and that is away from the substrate 10.

S900: Form a source 91, a drain 92, and a gate 93 on a side that is of the barrier layer 80 and that is away from the substrate 10.

In some examples, metal-organic chemical vapor deposition, molecular beam epitaxy, or physical vapor deposition may be used as a growth technology, to form the insertion layer 70 and the barrier layer 80. Reactive gas used when the insertion layer 70 and the barrier layer 80 are formed may be selected based on materials of the insertion layer 70 and the barrier layer 80.

A reaction temperature at which the insertion layer 70 and the barrier layer 80 are formed is not limited in embodiments of this application. For example, when a temperature is 1060°C, the insertion layer 70 may be formed on the side that is of the heteroepitaxial layer 30 and that is away from the substrate 10, and the barrier layer 80 may be formed on the side that is of the insertion layer 70 and that is away from the substrate 10.

In the descriptions of this specification, the described specific features, structures, materials, or characteristics may be combined in a proper manner in any one or more of embodiments or examples.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A semiconductor device, comprising:
a substrate;
an aluminum nitride buffer layer, located on a side of the substrate, wherein the aluminum nitride buffer layer comprises a first surface and a second surface, the first surface is farther away from the substrate than the second surface, a plurality of dents are randomly distributed on the first surface, and there are spacings between bottoms of the dents and the second surface; and
a heteroepitaxial layer, located on a side that is of the aluminum nitride buffer layer and that is away from the substrate.

2. The semiconductor device according to claim 1, wherein a thickness of the aluminum nitride buffer layer ranges from 10 nm to 1000 nm.

3. The semiconductor device according to claim 1 or 2, wherein sizes of openings of the plurality of dents in a direction parallel to the substrate range from 10 nm to 500 nm.

4. The semiconductor device according to any one of claims 1 to 3, wherein the openings of the plurality of dents are in a shape of a circle, an ellipse, a hexagon, or an irregular pattern.

5. The semiconductor device according to any one of claims 1 to 4, wherein the openings of the plurality of dents have different sizes in the direction parallel to the substrate.

6. The semiconductor device according to any one of claims 1 to 5, wherein minimum spacings between the plurality of dents are less than 1 µm in the direction parallel to the substrate.

7. The semiconductor device according to any one of claims 1 to 6, wherein the minimum spacings between the plurality of dents are different in the direction parallel to the substrate.

8. The semiconductor device according to any one of claims 1 to 7, wherein spacings between the second surface and the bottoms of the plurality of dents are different.

9. The semiconductor device according to any one of claims 1 to 8, wherein the spacings between the second surface and the bottoms of the plurality of dents are greater than or equal to one tenth of the thickness of the aluminum nitride buffer layer.

10. The semiconductor device according to any one of claims 1 to 9, further comprising:
a restoration layer, located between the aluminum nitride buffer layer and the heteroepitaxial layer, wherein the restoration layer comprises a third surface and a fourth surface, the third surface is farther away from the substrate than the fourth surface, a plurality of gaps are randomly distributed on the fourth surface, the gaps extend in a direction perpendicular to the substrate, one gap communicates with one dent, a size, in a specified direction, of an end that is of the gap and that is away from the dent is less than a size, in the specified direction, of an end that is of the gap and that is close to the dent, and the specified direction is parallel to the substrate.

11. The semiconductor device according to claim 10, wherein a size of the gap in the specified direction gradually decreases in a direction that is perpendicular to the substrate and that is away from the substrate.

12. The semiconductor device according to claim 10 or 11, wherein the gap is in a conical shape.

13. The semiconductor device according to any one of claims 10 to 12, wherein the plurality of gaps have different sizes in the direction perpendicular to the substrate.

14. The semiconductor device according to any one of claims 10 to 13, wherein a material of the restoration layer comprises aluminum nitride, gallium nitride, or aluminum gallium nitride.

15. The semiconductor device according to any one of claims 10 to 14, wherein a thickness of the restoration layer ranges from 10 nm to 1000 nm.

16. The semiconductor device according to any one of claims 10 to 15, further comprising:
an aluminum gallium nitride transition layer, located between the restoration layer and the heteroepitaxial layer.

17. The semiconductor device according to any one of claims 1 to 16, wherein residual strain of a plurality of film layers on the substrate is less than or equal to -0.1%.

18. The semiconductor device according to any one of claims 1 to 16, wherein the semiconductor device further comprises a first electrode and a second electrode, wherein the first electrode is located on a side that is of the substrate and that is away from the aluminum nitride buffer layer, and the second electrode is located on a side that is of the heteroepitaxial layer and that is away from the substrate; or both the first electrode and the second electrode are located on a side that is of the heteroepitaxial layer and that is away from the substrate.

19. The semiconductor device according to any one of claims 1 to 16, further comprising:
an insertion layer, located on the side that is of the heteroepitaxial layer and that is away from the substrate;
a barrier layer, located on a side that is of the insertion layer and that is away from the substrate; and
a source, a drain, and a gate, located on a side that is of the barrier layer and that is away from the substrate.

20. A manufacturing method of a semiconductor device, comprising:
forming an aluminum nitride buffer layer on a substrate, wherein the aluminum nitride buffer layer comprises a first surface and a second surface, the first surface is farther away from the substrate than the second surface, a plurality of randomly distributed dents are spontaneously formed on the first surface by controlling a growth condition of the aluminum nitride buffer layer, and there are spacings between bottoms of the dents and the second surface; and
forming a heteroepitaxial layer on a side that is of the aluminum nitride buffer layer and that is away from the substrate.

21. The manufacturing method according to claim 20, wherein forming the aluminum nitride buffer layer on the substrate comprises:
forming the aluminum nitride buffer layer on the substrate based on a first growth condition, wherein the first growth condition comprises at least one of the following three conditions:
a molar ratio of a nitrogen element to an aluminum element is greater than or equal to 2500, a temperature is greater than or equal to 700°C and less than or equal to 1000°C, and pressure is greater than 200 millibars.

22. The manufacturing method according to claim 20 or 21, wherein before forming the heteroepitaxial layer on the side that is of the aluminum nitride buffer layer and that is away from the substrate, the manufacturing method further comprises:
forming a restoration layer on the side that is of the aluminum nitride buffer layer and that is away from the substrate, wherein the restoration layer comprises a third surface and a fourth surface, the third surface is farther away from the substrate than the fourth surface, a plurality of randomly distributed gaps are spontaneously formed on the fourth surface by controlling a growth condition of the restoration layer, the gaps extend in a direction perpendicular to the substrate, one gap communicates with one dent, a size, in a specified direction, of an end that is of the gap and that is away from the dent is less than a size, in the specified direction, of an end that is of the gap and that is close to the dent, and the specified direction is parallel to the substrate.

23. The manufacturing method according to claim 22, wherein a material of the restoration layer comprises aluminum nitride; and forming the restoration layer on the side that is of the aluminum nitride buffer layer and that is away from the substrate comprises:
forming, based on a second growth condition, the restoration layer on the side that is of the aluminum nitride buffer layer and that is away from the substrate, wherein the second growth condition comprises at least one of the following three conditions:
a molar ratio of a nitrogen element to an aluminum element is less than or equal to 1500, a temperature is greater than 1000°C and less than or equal to 1300°C, and pressure is less than or equal to 200 millibars.

24. The manufacturing method according to claim 22, wherein a material of the restoration layer comprises gallium nitride or aluminum gallium nitride; and forming the restoration layer on the side that is of the aluminum nitride buffer layer and that is away from the substrate comprises:
forming, based on a third growth condition, the restoration layer on the side that is of the aluminum nitride buffer layer and that is away from the substrate, wherein the third growth condition comprises at least one of the following three conditions:
a molar ratio of a group V element to a group III element is less than or equal to 3000, a temperature is greater than or equal to 900°C and less than or equal to 1300°C, and pressure is less than or equal to 200 millibars, wherein the group V element comprises a nitrogen element, and the group III element comprises a gallium element, or the group III element comprises an aluminum element and a gallium element.

25. A chip, comprising:
a package substrate; and
the semiconductor device according to any one of claims 1 to 19, wherein the semiconductor device is electrically connected to the package substrate.

26. An electronic device, comprising:
a circuit board; and
the chip according to claim 25, wherein the chip is electrically connected to the circuit board.
